# EUROPEAN PATENT SPECIFICATION

(11) **EP 4 422 077 B1**
(45) Date of publication and mention of the grant of the patent: **04.11.2026**
(21) Application number: 24157837.6
(22) Date of filing: 15.02.2024
(51) Int. Cl.: H03L 1/02, H03L 7/099, G05F 1/56

(54) **A VOLTAGE-CURRENT CONVERSION CIRCUIT, A VOLTAGE-CONTROLLED OSCILATOR, AND A PHASE-LOCKED LOOP CIRCUIT**
SPANNUNGSSTROMWANDLERSCHALTUNG, SPANNUNGSGESTEUERTER OSZILLATOR UND PHASENREGELKREISSCHALTUNG
CIRCUIT DE CONVERSION TENSION-COURANT, OSCILLATEUR COMMANDÉ EN TENSION ET CIRCUIT DE BOUCLE À VERROUILLAGE DE PHASE

(30) Priority: 23.02.2023 KR 20230024209
(43) Date of publication of application: 28.08.2024
(73) Proprietor: LX Semicon Co., Ltd., Daejeon 34027 (KR)
(72) Inventor: SOHN, Ji Hoon, 34027 Daejeon (KR); MOON, Yong Hwan, 34027 Daejeon (KR); YOO, Jae Wook, 34027 Daejeon (KR)
(74) Representative: Goddar, Heinz J.

(56) References cited:
- EP-A1- 3 487 076
- US-A1- 2009 079 470
- US-B1- 7 474 130

## Description

### BACKGROUND OF THE DISCLOSURE

### Field

Embodiments relate to a voltage-current conversion circuit, a voltage-controlled oscillator, and a phase-locked loop circuit.

### Discussion of the Related Art

An electronic device can comprise a voltage-controlled oscillator (VCO) that varies the frequency of an output signal using an input voltage. For example, the voltage-controlled oscillator can output a signal with a frequency corresponding to the input voltage or input current. For example, an oscillator built into the electronic device can generate a clock signal corresponding to a preset frequency, and the electronic device can operate based on the clock signal of the oscillator. The oscillators must generate accurate and stable clock signal for the reliability of the electronic device.

The oscillator can be implemented as a ring oscillator. For example, a ring oscillator can comprise a plurality of inverters connected to each other in a loop shape. In the ring oscillator, the frequency of the output signal can be controlled using the input current. Therefore, the control voltage for controlling the oscillator can be converted into a control current to control the ring oscillator and then input to the ring oscillator. A voltage-current conversion circuit can be added to the front end of the ring oscillator to convert the control voltage into a control current.

The voltage-current conversion circuit can be implemented in various ways. When the voltage-current conversion circuit is configured as a differential structure, there is a disadvantage that it is difficult to use the voltage-current conversion circuit at a relatively low supply power because an operating voltage is required in a region where the current source is saturated. When the voltage-current conversion circuit is composed of a single structure, a threshold voltage of an input transistor through which the control voltage is input can change according to changes in temperature. There is a disadvantage that the compliance range of the voltage-current conversion circuit changes depending on the change in the threshold voltage of the input transistor.

Documents EP 3 487 076 A1, US 7 474 130 B1, and US 2009/079470 A1 disclose voltage current converters with reduced sensitivity to temperature. However, there remains a need to develop a technology that can output a signal with a stable frequency from a ring oscillator by consistently outputting a control current corresponding to the control voltage regardless of changes in temperature.

### SUMMARY OF THE DISCLOSURE

The purpose of the disclosure is to provide a voltage-current conversion circuit, defined in claims 1-6, a voltage-controlled oscillator, defined in claim 7, and a phase-locked loop circuit, defined in claim 8, that can operate at a relatively low supply power and have constant characteristics even when temperature changes.

The second circuit can be a replica circuit of the first circuit.

The third circuit can form a current mirror with the second circuit to output a third current corresponding to the second current, and output the control current based on the first current and the third current.

The control current can be generated based on the difference between the first current and the third current.

The reference voltage can be a preset voltage.

The second transistor is a first NMOS transistor, and the eight transistor is a second NMOS transistor.

The first NMOS transistor and the second NMOS transistor can have the same temperature characteristics.

According to another aspect of the embodiment to achieve the above or other purposes, a voltage-current conversion circuit, comprising: a first circuit configured to receive a control voltage and output a first current corresponding to the control voltage; a second circuit configured to receive a reference voltage and output a second current corresponding to the reference voltage; and a third circuit configured to output a control current corresponding to the control voltage based on the first current and the second current.

The second circuit can be a replica circuit of the first circuit.

The third circuit can form a current mirror with the second circuit to output a third current corresponding to the second current, and output the control current based on the first current and the third current.

The control current can be generated based on the difference between the first current and the third current.

The reference voltage can be a preset voltage.

The first circuit can comprise a first NMOS transistor having a gate terminal through which the control voltage is input, and the second circuit can comprise a second NMOS transistor having a gate terminal through which the reference voltage is input.

The first NMOS transistor and the second NMOS transistor have the same temperature characteristics.

According to another aspect of the embodiment to achieve the above or other objects, a phase-locked loop circuit, comprising: a phase detector configured to detect a phase difference between a first input signal and a second input signal; a filter configured to charge or discharge based on the phase difference; a voltage-current conversion circuit configured to output a control current corresponding to a control voltage applied to the filter; and an oscillator configured to output an output signal with a frequency corresponding to the control current, wherein the voltage-current conversion circuit comprises: a first circuit configured to output a first current corresponding to the control voltage; a second circuit configured to output a second current corresponding to a reference voltage; and a third circuit configured to output the control current based on the first current and the second current.

The second circuit can be a replica circuit of the first circuit.

The third circuit can form a current mirror with the second circuit to output a third current corresponding to the second current, and output the control current based on the first current and the third current.

The control current can be generated based on the difference between the first current and the third current.

The second input signal can correspond to the output signal of the oscillator.

The oscillator can comprise a ring oscillator.

The effects of the voltage-current conversion circuit, the voltage-controlled oscillator, and the phase-locked loop circuit according to the embodiment are described as follows.

According to an embodiment, by using a voltage-current conversion circuit, it is possible to design a voltage-controlled oscillator that can operate even with a relatively low supply power and have stable characteristics even when the temperature changes.

According to the embodiment, since it has a current output through a replica circuit that constitutes a voltage-current conversion circuit, it is suitable for implementing a current mirror and can have high scalability. Accordingly, the voltage-current conversion circuit can be easily configured as a multi-lane circuit.

### BRIEF DESCRIPTION OF THE DRAWINGS

FIG. 1 is a block diagram showing a phase-locked loop circuit according to a first embodiment.
FIG. 2 is a block diagram showing a phase-locked loop circuit according to a second embodiment.
FIG. 3 is a diagram showing a voltage-current conversion circuit according to a first example useful for the understanding of the present invention.
FIG. 4 is a diagram showing a voltage-current conversion circuit according to a second example useful for the understanding of the present invention.
FIG. 5 is a graph showing the relationship between the control voltage and the control current according to a first example.
FIG. 6 is a graph showing the relationship between the control voltage and the control current according to a second example.
FIG. 7 is a diagram showing a voltage-current conversion circuit according to an embodiment.
FIG. 8 is a graph showing an example of the relationship between the control voltage and the control current according to an embodiment.
FIG. 9 is a graph showing another example of the relationship between the control voltage and the control current according to an embodiment.
FIG. 10 is a graph showing another example of the relationship between the control voltage and the control current according to an embodiment.

### DETAILED DESCRIPTION OF EMBODIMENTS

Hereinafter, some embodiments of the present invention will be described in detail through exemplary drawings. When adding reference numerals to components in each drawing, it should be noted that identical components are given the same reference numerals as much as possible even if they are shown in different drawings. Additionally, in describing the present invention, if it is determined that a detailed description of a related known configuration or function can obscure the gist of the present invention, the detailed description will be omitted.

Additionally, when describing the components of the present invention, terms such as first, second, A, B, (a), and (b) can be used. These terms are only used to distinguish the component from other components, and the nature, sequence, or order of the component is not limited by the term. It should be understood that when a component is described as being "connected," "coupled," or "linked" to another component, the component can be directly connected or connected to the other component, but another component can be "connected," "coupled," or "linked" between each component.

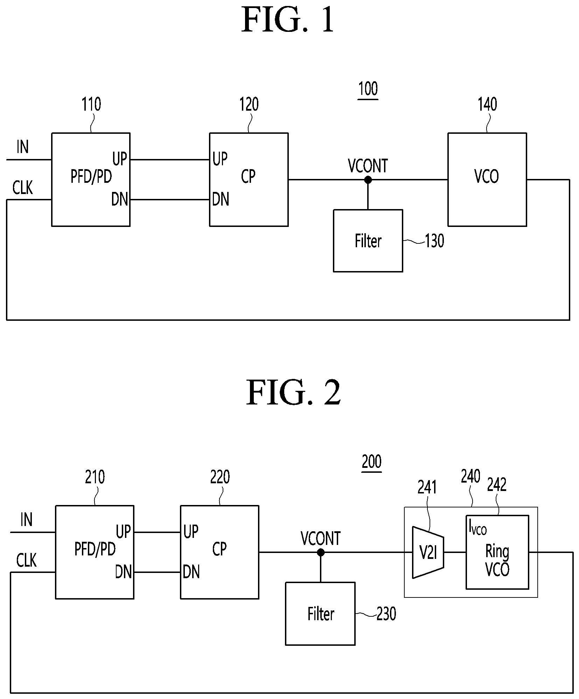

FIG. 1 is a block diagram showing a phase-locked loop circuit according to a first embodiment.

Referring to FIG. 1, the phase locked loop (PLL) circuit 100 according to the first embodiment can comprise a phase detector (PD) 110, a filter 130, and a voltage-controlled oscillator (VCO) 140. The PLL 100 according to the first embodiment can further comprise a charge pump (CP) 120. If the PD 110 comprises a frequency detection function, it can be referred to as a phase frequency detector PFD. The filter 130 can comprise a loop filter.

The PD 110 can receive an input signal IN and a clock signal CLK, respectively. The PD 110 can compare the input signal IN and the phases of the clock signal CLK and output a voltage signal according to the result of the phase comparison. As shown in FIG. 1, the clock signal CLK can be a signal fed back from the output signal of the VCO 140, and can correspond to the output signal of the VCO 140 or a signal obtained by dividing the output signal of the VCO 140 by an integer multiple. For example, the PD 110 can output a voltage signal proportional to the phase difference or frequency difference between the input signal IN and the clock signal CLK, but is not limited to thereto. The PD 110 can output a rising signal UP or a falling signal DN based on the phase difference or frequency difference between the input signal IN and the clock signal CLK. A capacitor included in the filter 130 can be charged or discharged according to the rising signal UP or the falling signal DN output from the PD 110.

The charge pump 120 can charge or discharge the filter 130 by controlling the flow of control current based on the rising signal UP or the falling signal DN output from the PD 110. For example, when the charge pump 120 receives the rising signal UP from the PD 110, the charge pump 120 can charge the capacitor of the filter 130. On the other hand, when the charge pump 120 receives the falling signal DN from the PD 110, the charge pump 120 can discharge the capacitor of the filter 130.

As the capacitor of the filter 130 is charged or discharged, the size of the voltage applied to the filter (hereinafter referred to as 'control voltage VCONT' for convenience of explanation) can change.

The VCO 140 can receive a control voltage VCONT and generate an output signal with a frequency corresponding to the input control voltage VCONT. For example, the VCO 140 can adjust the frequency of the signal output from the VCO 140 by adjusting the size of the control voltage VCONT.

FIG. 2 is a block diagram showing a phase-locked loop circuit according to a second embodiment.

Referring to FIG. 2, the phase locked loop (PLL) circuit 200 according to the second embodiment can comprise a phase detector (PD) 210, a filter 230, and a voltage-controlled oscillator (VCO) 240. The PLL 200 according to the embodiment can further comprise a charge pump (CP) 220. If the PD 210 comprises a frequency detection function, it can be referred to as a phase frequency detector PFD. The filter 230 can comprise a loop filter. Since the PD 210, charge pump 220, and filter 230 shown in FIG. 2 perform the same or similar functions as the PD 110, charge pump 120, and filter 130 described in FIG. 1, respectively, detailed description will be omitted.

The VCO 240 included in the PLL 200 can be implemented as a ring oscillator (or ring VCO 242). As shown in FIG. 2, when the VCO 240 is implemented as a ring VCO 242, the frequency of the output signal can be adjusted based on the input current I_{VCO}. To this end, a voltage-current conversion circuit (V2I) 241 capable of converting the control voltage VCONT into the control current I_{VCO} can be added to the front of the ring VCO 242. For example, the V2I 241 and the ring VCO 242 can be understood as components included in the VCO 240.

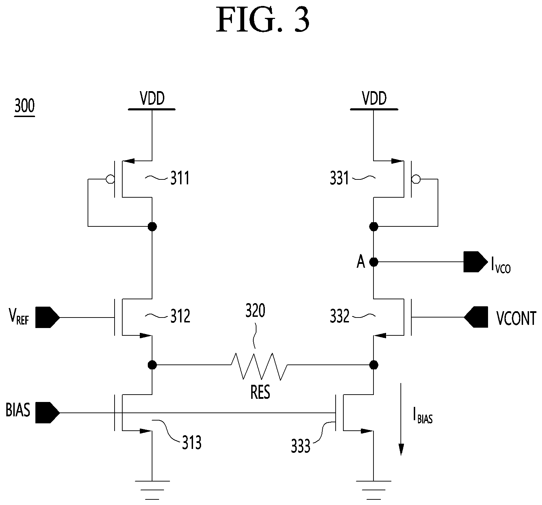

Hereinafter, with reference to FIGS. 3 to 10, embodiments of the V2I 241 included in the PLL 200 or the VCO 240 will be described. However, the V2I 241, which will be described later, may not be included in the PLL 200 or the VCO 240 but can be included in other components.

FIG. 3 is a diagram showing a voltage-current conversion circuit according to a first example useful for the understanding of the present invention.

Referring to FIGS. 2 and 3, the voltage-current conversion circuit 300 according to the first embodiment can comprise a first transistor 311, a second transistor 312, a third transistor 313, and a fourth transistor 331, a fifth transistor 332, a sixth transistor 333, and a resistor (RES) 320. The first transistor 311 and the fourth transistor 331 can be PMOS transistors, but are not limited thereto. The second transistor 312, third transistor 313, fifth transistor 332, and sixth transistor 333 can be NMOS transistors, but are not limited thereto. The voltage-current conversion circuit 300 according to the first embodiment can be the V2I 241 shown in FIG. 2. The voltage-current conversion circuit 300 shown in FIG. 3 can be referred to as a differential structure, but is not limited to this term.

One terminal (e.g., source terminal) of the first transistor 311 can be connected to a line supplying a power voltage VDD, and the other terminal (e.g., drain terminal) of the first transistor 311 can be connected to one terminal (e.g., a drain terminal) of the second transistor 312. A gate terminal of the first transistor 311 can be connected to the other terminal (e.g., drain terminal) of the first transistor 311, thereby forming a diode-connected load structure.

One terminal (e.g., drain terminal) of the second transistor 312 can be connected to the other terminal (e.g., drain terminal) of the first transistor 311. The other terminal (e.g., source terminal) of the second transistor 312 can be connected to one terminal (e.g., drain terminal) of the third transistor 313. A reference voltage V_{REF} can be input to a gate terminal of the second transistor 312. The reference voltage can be a preset voltage.

One terminal (e.g., drain terminal) of the third transistor 313 can be connected to the other terminal (e.g., source terminal) of the second transistor 312. The other terminal (e.g., source terminal) of the third transistor 313 can be grounded. A bias voltage BIAS can be input to a gate terminal of the third transistor 313.

One terminal (e.g., source terminal) of the fourth transistor 331 can be connected to a line supplying the power voltage VDD, and the other terminal (e.g., drain terminal) of the fourth transistor 331 can be connected to one terminal (e.g., a drain terminal) of the fifth transistor 332. A gate terminal of the fourth transistor 331 can be connected to the other terminal (e.g., drain terminal) of the fourth transistor 331, thereby forming a diode-connected load structure.

One terminal (e.g., drain terminal) of the fifth transistor 332 can be connected to the other terminal (e.g., drain terminal) of the fourth transistor 331. The other terminal (e.g., source terminal) of the fifth transistor 332 can be connected to one terminal (e.g., drain terminal) of the sixth transistor 333. A control voltage VCONT can be input to a gate terminal of the fifth transistor 332.

One terminal (e.g., drain terminal) of the sixth transistor 333 can be connected to the other terminal (e.g., source terminal) of the fifth transistor 332. The other terminal (e.g., source terminal) of the sixth transistor 333 can be grounded. A bias voltage BIAS can be input to a gate terminal of the sixth transistor 333.

The other terminal (e.g., source terminal) of the second transistor 312 can be connected to the other terminal (e.g., source terminal) of the fifth transistor 332. As shown in FIG. 3, the RES 320 can be connected between the other terminal (e.g., source terminal) of the second transistor 312 and the other terminal (e.g., source terminal) of the fifth transistor 332, which are connected to each other.

The third transistor 313 can be a current source, and a bias current I_{BIAS} can flow between the drain terminal and the source terminal thereof. Additionally, the sixth transistor 333 can be a current source, and a bias current I_{BIAS} can flow between the drain terminal and the source terminal thereof.

The fifth transistor 332 can serve as an input transistor through which the control voltage VCONT is input. Depending on the size of the control voltage VCONT input to the gate terminal of the fifth transistor 332, the size of the control current I_{VCO} flowing through node A between the fourth transistor 331 and the fifth transistor 332 and the line connected to the ring oscillator 242can be controlled. Accordingly, the voltage-current conversion circuit 300 can perform the function of converting and outputting the input control voltage VCONT into a control current I_{VCO}. The control current I_{VCO} flowing to the ring oscillator 242 through the node A can be determined according to a comparison result between the control voltage VCONT input to the gate terminal of the fifth transistor 332 and the reference voltage V_{REF} input to the gate terminal of the second transistor 312. For example, when the control voltage VCONT is high compared to the reference voltage V_{REF}, the control current I_{VCO} can increase. As the control current I_{VCO} increases, the frequency of the signal output from the ring oscillator 242 can increase. On the other hand, when the control voltage VCONT is low compared to the reference voltage V_{REF}, the control current I_{VCO} can decrease. As the control current I_{VCO} decreases, the frequency of the signal output from the ring oscillator 242 can decrease.

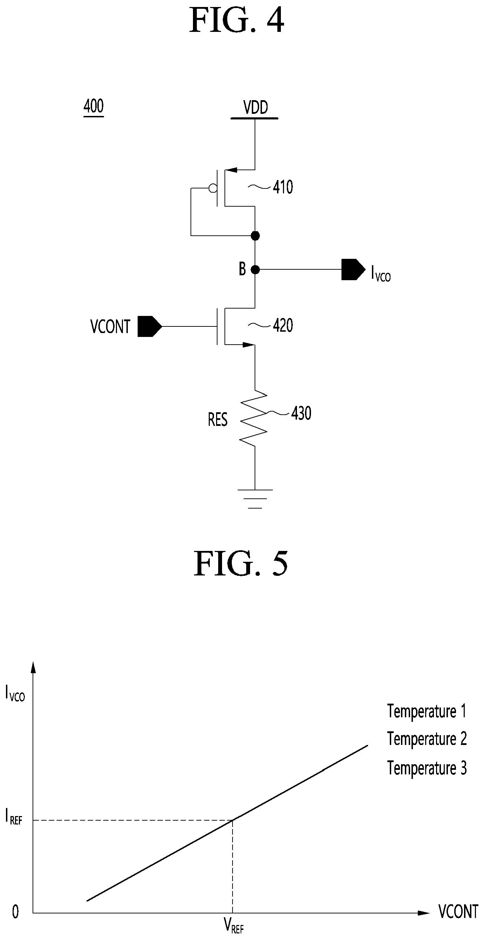

FIG. 5 is a graph showing the relationship between the control voltage and the control current according to a first example.

When implementing the voltage-current conversion circuit 300 as shown in FIG. 3, as shown in FIG. 5, assuming that the bias current I_{BIAS} and the resistance value of the RES 320 are constant, it can have characteristics that are independent of temperature changes. For example, it can be seen that the same characteristics are all exhibited at a first temperature (e.g., high temperature, Temperature 1), a second temperature (e.g., medium temperature, Temperature 2), and a third temperature (e.g., low temperature, Temperature 3). That is, at the first temperature Temperature 1 to the third temperature Temperature 3, the control voltage VCONT and the control current I_{VCO} can have the same proportional relationship. Meanwhile, the voltage current conversion circuit 300 has the disadvantage of being difficult to use at low supply power because it requires a drain-source voltage so that the third transistor 313 and the sixth transistor 333, which are current sources, can operate in the saturation region.

FIG. 4 is a diagram showing a voltage-current conversion circuit according to a second example useful for the understanding of the present invention.

Referring to FIGS. 2 and 4, the voltage-current conversion circuit 400 according to the second embodiment can comprise a first transistor 410, a second transistor 420, and a resistor (RES) 430. The first transistor 410 can be a PMOS transistor, but is not limited thereto. The second transistor 420 can be an NMOS transistor, but is not limited thereto. The voltage-current conversion circuit 400 according to the second embodiment can be the V2I 241 shown in FIG. 2. The voltage-current conversion circuit 400 shown in FIG. 4 can be referred to as a single structure, but is not limited to this term.

One terminal (e.g., source terminal) of the first transistor 410 can be connected to a line that supplies a power voltage VDD, and the other terminal (e.g., drain terminal) can be connected to one terminal (e.g., a drain terminal) of the second transistor 420. A gate terminal of the first transistor 410 can be connected to the other terminal (e.g., drain terminal) of the first transistor 410, thereby forming a diode-connected load structure.

One terminal (e.g., drain terminal) of the second transistor 420 can be connected to the other terminal (e.g., drain terminal) of the first transistor 410. The other terminal (e.g., source terminal) of the second transistor 420 can be connected to one terminal of the RES 430. A control voltage VCONT can be input to a gate terminal of the second transistor 420. The other terminal of the RES 430 can be grounded.

The second transistor 420 can serve as an input transistor through which the control voltage VCONT is input. Depending on the size of the control voltage VCONT input to the gate terminal of the second transistor 420, the size of the control current I_{VCO} flowing through node B between the first transistor 410 and the second transistor 420 and the line connected to the ring oscillator 242can be controlled. Accordingly, the voltage-current conversion circuit 400 can perform the function of converting and outputting the input control voltage VCONT into a control current I_{VCO}. For example, when increasing the control voltage VCONT, the control current I_{VCO} can increase. As the control current I_{VCO} increases, the frequency of the signal output from the ring oscillator 242 can increase. On the other hand, when the control voltage VCONT is reduced, the control current I_{VCO} can decrease. As the control current I_{VCO} decreases, the frequency of the signal output from the ring oscillator 242 can decrease.

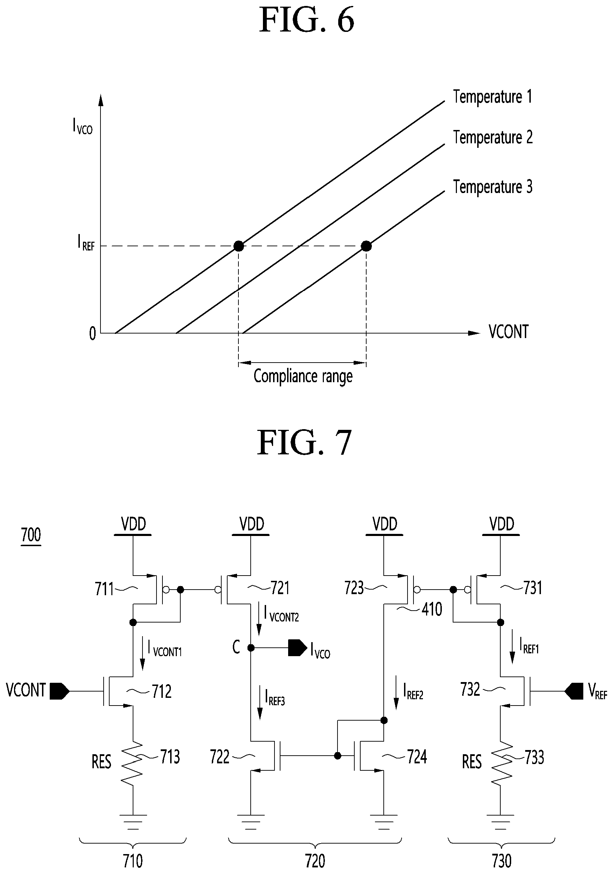

Referring to FIG. 4, compared to FIG. 3, because there is no current source (the third transistor 313 and the sixth transistor 333 in FIG. 3), the single-structure voltage-current conversion circuit 400 can be used even with low supply power. However, when the temperature changes, the threshold voltage of the second transistor 420, which serves as an input transistor, changes. Accordingly, the operating range can change as shown in FIG. 6.

FIG. 6 is a graph showing the relationship between the control voltage and the control current according to a second example.

When implementing the voltage-current conversion circuit 400 according to the second embodiment as shown in FIG. 4, as shown in FIG. 6, it can be seen that the control current I_{VCO} output in response to the control voltage VCONT changes depending on the temperature change. For example, in order to output a specific reference current I_{REF}, there is a disadvantage that different input voltages VCONT must be supplied to the voltage-current conversion circuit 400 according to the second embodiment according to each of the different first temperatures Temperature 1, the second temperatures Temperature 2, and the third temperatures Temperature 3.

Hereinafter, with reference to FIGS. 7 to 10, a voltage-current conversion circuit that can operate even with a relatively low supply power and has stable characteristics even when temperature changes will be described.

FIG. 7 is a diagram showing a voltage-current conversion circuit according to an embodiment.

Referring to FIGS. 2 and 7, the voltage-current conversion circuit 700 according to the embodiment comprises a first conversion circuit 710 (e.g., first circuit) and a second conversion circuit 730 (e.g., a second circuit), and a subtraction circuit 720 (e.g., a third circuit). The first conversion circuit 710 can be configured in the same or similar form as the structure described above in FIG. 4 and can be referred to as a single structure circuit, but is not limited to this term. The second conversion circuit 730 can be configured in the same or similar form as the first conversion circuit 710 and can be referred to as a replica circuit, but is not limited to this term.

The first conversion circuit 710 comprises a first transistor 711, a second transistor 712, and a first resistor (RES) 713. The first transistor 711 can be a PMOS transistor, but is not limited thereto. The second transistor 712 can be an NMOS transistor, but is not limited thereto.

One terminal (e.g., source terminal) of the first transistor 711 is connected to a line that supplies a power voltage VDD, and the other terminal (e.g., drain terminal) is connected to one terminal (e.g., a drain terminal) of the second transistor 712. A gate terminal of the first transistor 711 is connected to the other terminal (e.g., drain terminal) of the first transistor 711, thereby forming a diode-connected load structure.

One terminal (e.g., drain terminal) of the second transistor 712 is connected to the other terminal (e.g., drain terminal) of the first transistor 711. The other terminal (e.g., source terminal) of the second transistor 712 is connected to one terminal of the first resistor 713. A control voltage VCONT is input to a gate terminal of the second transistor 712. The other terminal of the first resistor 713 is grounded.

The second transistor 712 can serve as an input transistor through which the control voltage VCONT is input. The size of the current I_{VCONT1} (e.g., first current) flowing between the first transistor 711 and the second transistor 712 can be controlled according to the size of the control voltage VCONT input to the gate terminal of the second transistor 712.

The second conversion circuit 730 comprises a seventh transistor 731, an eighth transistor 732, and a second resistor (RES) 733. The seventh transistor 731 can be a PMOS transistor, but is not limited thereto. The eighth transistor 732 can be an NMOS transistor, but is not limited thereto.

One terminal (e.g., source terminal) of the seventh transistor 731 is connected to a line that supplies a power supply voltage VDD, and the other terminal (e.g., drain terminal) is connected to one terminal (e.g., drain terminal) of the eighth transistor 732. A gate terminal of the seventh transistor 731 is connected to the other terminal (e.g., drain terminal) of the seventh transistor 731, thereby forming a diode-connected load structure.

One terminal (e.g., drain terminal) of the eighth transistor 732 is connected to the other terminal (e.g., drain terminal) of the seventh transistor 731. The other terminal (e.g., source terminal) of the eighth transistor 732 is connected to one terminal of the second resistor 733. A reference voltage V_{REF} is input to a gate terminal of the eighth transistor 732. The other terminal of the second resistor 733 is grounded.

The eighth transistor 732 can serve as an input transistor through which the reference voltage V_{REF} is input. The size of the current I_{REF1} (e.g., second current) flowing between the seventh transistor 731 and the eighth transistor 732 can be controlled according to the size of the reference voltage V_{REF} input to the gate terminal of the eighth transistor 732.

The subtraction circuit 720 comprises a third transistor 721, a fourth transistor 722, a fifth transistor 723, and a sixth transistor 724. The third transistor 721 and the fifth transistor 723 can be PMOS transistors, but are not limited thereto. The fourth transistor 722 and the sixth transistor 724 can be NMOS transistors, but are not limited thereto.

One terminal (e.g., source terminal) of the third transistor 721 is connected to a line supplying a power voltage VDD, and the other terminal (e.g., drain terminal) can be connected to one terminal (e.g., a drain terminal) of the fourth transistor 722.

One terminal (e.g., drain terminal) of the fourth transistor 722 is connected to the other terminal (e.g., drain terminal) of the third transistor 721. The other terminal (e.g., source terminal) of the fourth transistor 722 is grounded.

One terminal (e.g., source terminal) of the fifth transistor 723 is connected to a line that supplies a power voltage VDD, and the other terminal (e.g., drain terminal) is connected to one terminal (e.g., a drain terminal) of the sixth transistor 724.

One terminal (e.g., drain terminal) of the sixth transistor 724 is connected to the other terminal (e.g., drain terminal) of the fifth transistor 723. The other terminal (e.g., source terminal) of the sixth transistor 724 is grounded. A gate terminal of the sixth transistor 724 is connected to one terminal (e.g., drain terminal) of the sixth transistor 724, thereby forming a diode-connected load structure.

The gate terminal of the first transistor 711 included in the first conversion circuit 710 and the gate terminal of the third transistor 721 included in the subtraction circuit 720 can be connected to each other to form a current mirror circuit. Accordingly, the current I_{VCONT2} flowing between the third transistor 721 of the subtraction circuit 720 and node C can be determined based on the current I_{VCONT1} (e.g., first current) flowing between the first transistor 711 and the second transistor 712 of the first conversion circuit 710. For example, the current I_{VCONT2} can be equal to or proportional to the current I_{VCONT1}.

The gate terminal of the seventh transistor 731 included in the second conversion circuit 730 and the gate terminal of the fifth transistor 723 included in the subtraction circuit 720 can be connected to each other to form a current mirror circuit. Accordingly, the current I_{REF2} flowing between the fifth transistor 723 and the sixth transistor 724 of the subtraction circuit 720 can be first determined based on the current I_{REF1} (e.g., second current) flowing between the seventh transistor 731 and the eighth transistor 732 of the second conversion circuit 730. For example, the current I_{REF2} can be equal to or proportional to the current I_{REF1}.

Within the subtraction circuit 720, the gate terminal of the fourth transistor 722 and the gate terminal of the sixth transistor 724 can be connected to each other, thereby forming a current mirror circuit. Accordingly, within the subtraction circuit 720, the current I_{REF3} flowing between the node C and the fourth transistor 722 can be determined based on the current I_{REF2} flowing between the fifth transistor 723 and the sixth transistor 724. For example, the current I_{REF3} can be equal to or proportional to the current I_{REF2}. Accordingly, within the subtraction circuit 720, the current I_{REF3} flowing between node C and the fourth transistor 722 can be determined based on the current I_{REF1} (e.g., second current) flowing between the seventh transistor 731 and the eighth transistor 732 of the second conversion circuit 730. Since the current I_{REF3} is equal to or proportional to the current I_{REF1}, it can be referred to as the replica current I_{Replica}, but is not limited to this term.

The second transistor 712 can serve as an input transistor through which the control voltage VCONT is input. The size of the current I_{VCONT2} flowing between the third transistor 721 and the node C can be controlled according to the size of the control voltage VCONT input to the gate terminal of the second transistor 712. Additionally, the eighth transistor 732 can serve as an input transistor through which the reference voltage V_{REF} is input. The size of the current I_{REF3} flowing between the node C and the fourth transistor 722 can be controlled according to the size of the reference voltage V_{REF} input to the gate terminal of the eighth transistor 732.

The ring oscillator 242 can be connected to through the node C between the third transistor 721 and the fourth transistor 722. The size of the control current I_{VCO} flowing through the line connected to the ring oscillator 242 at the node C can correspond to the difference between the current I_{VCONT2} and the current I_{REF3}. Assuming that the reference voltage V_{REF} is a constant value (e.g., VDD/2), the current I_{REF3} can also have a constant value. Accordingly, the size of the control current I_{VCO} flowing through the line connected to the ring oscillator 242 at the node C can vary depending on the size of the current I_{VCONT2}. The size of the current I_{VCONT2} can be adjusted by the input voltage VCONT input to the gate terminal of the second transistor 712. Accordingly, the size of the control current I_{VCO} flowing through the line connected to the ring oscillator 242 at the node C can be adjusted by the input voltage VCONT input to the gate terminal of the second transistor 712. Therefore, the voltage-current conversion circuit 700 according to the third embodiment can perform the function of converting and outputting the input control voltage VCONT into control current I_{VCO}. For example, when increasing the control voltage VCONT, the control current I_{VCO} can increase. As the control current I_{VCO} increases, the frequency of the signal output from the ring oscillator 242 can increase. On the other hand, when the control voltage VCONT is reduced, the control current I_{VCO} can decrease. As the control current I_{VCO} decreases, the frequency of the signal output from the ring oscillator 242 can decrease.

When constructing the voltage-current conversion circuit 700 according to the embodiment, it can have the same characteristics even if the temperature changes as in the voltage-current conversion circuit 300 having a single structure according to the first embodiment. In addition, when constructing the voltage-current conversion circuit 700 according to the third embodiment, as in the voltage-current conversion circuit 400 with a differential structure according to the second embodiment, there is no current source (the third transistor 313 and the sixth transistor 333 in FIG. 3), so that it can operate even in a relatively small output range.

For example, as shown in FIG. 7, since the second conversion circuit 730 constituting the replica circuit has the same or similar structure as the first conversion circuit 710, even if the temperature changes, the control current I_{VCO} obtained by subtracting the second current I_{REF1} from the first current I_{VCONT1} can be output, so that characteristics can be offset by temperature changes.

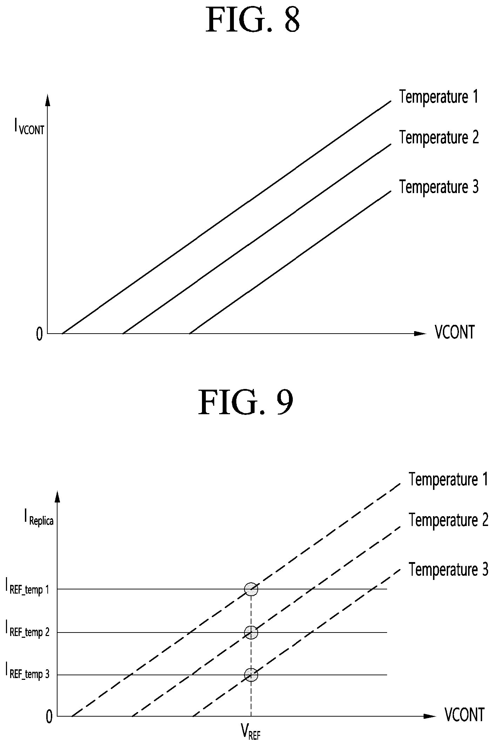

FIG. 8 is a graph showing an example of the relationship between the control voltage and the control current according to an embodiment.

Referring to FIG. 8, as shown in FIG. 7, as the input voltage VCONT increases or decreases, the current (e.g., I_{VCONT1}) can increase or decrease. Meanwhile, when the temperature changes, the threshold voltage of the second transistor 712, which serves as an input transistor, changes, which can cause the operating range to change as shown in FIG. 8.

FIG. 9 is a graph showing another example of the relationship between the control voltage and the control current according to an embodiment.

Referring to FIG. 9, as shown in FIG. 7, as the reference voltage V_{REF} is input, a current (e.g., a second current I_{REF1}) can be generated. Meanwhile, when the temperature changes, the threshold voltage of the eighth transistor 732, which serves as an input transistor, can change. Accordingly, as shown in FIG. 9, even if the same reference voltage V_{REF} is input, the size of the current (e.g., the second current I_{REF1}) can vary. For example, even if the same reference voltage V_{REF} is input, the size of the current (e.g., the second current I_{REF1}) can be different as the current I_{REF_temp1}, the current I_{REF_temp2}, and the current I_{REF_temp3} according to the first temperature Temperature 1, the second temperature Temperature 2 and the third temperature Temperature 3.

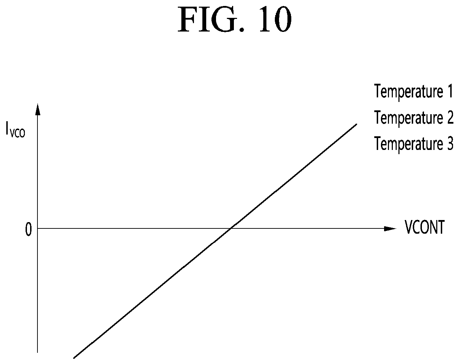

FIG. 10 is a graph showing another example of the relationship between the control voltage and the control current according to an embodiment.

Referring to FIG. 10, as shown in Figures 2 and 7, the size of the control current I_{VCO} flowing through the line connected to the ring oscillator 242 at node C can be generated by the difference between the first current I_{VCONT1} shown in FIG. 7 and the second current I_{REF1} shown in FIG. 9, so that effects according to temperature can be offset. Accordingly, the control current I_{VCO} can have a proportional relationship to the control voltage VCONT regardless of changes in temperature.

As described above, according to the embodiment, by using a voltage-current conversion circuit, a voltage-controlled oscillator with temperature-insensitive characteristics can be designed at relatively low supply power.

In addition, according to the embodiment, since the voltage-current conversion circuit has a current output through a replica circuit, it is suitable for implementing a current mirror and can have high scalability. Accordingly, the voltage-current conversion circuit can be easily configured as a multi-lane circuit.

## Claims

1. A voltage-current conversion circuit (241 and 700), comprising:
a first circuit (710) configured to receive a control voltage (VCONT) and output a first current (I_{VCONT1}) corresponding to the control voltage;
a second circuit (730) configured to receive a reference voltage (VREF) and output a second current (I_{REF1}) corresponding to the reference voltage; and
a third circuit (720) configured to output a control current (I_{VCO}) corresponding to the control voltage (VCONT) based on the first current (I_{VCONT1}) and the second current (I_{REF1}),
wherein
the first circuit (710) includes:
a first transistor (711) having a first terminal connected to a line that supplies a power voltage (VDD), and a second terminal and a gate terminal connected to each other to form a first diode connected load structure;
a second transistor (712) having a first terminal connected to the second and gate terminals of the first transistor (711), and a gate terminal to which the control voltage (VCONT); is input; and
a first resistor (713) having a first terminal connected to a second terminal of the second transistor (712), and a second terminal connected to a ground,
the second circuit (730) includes:
a seventh transistor (731) having a first terminal connected to the line that supplies the power voltage (VDD), and a second terminal and a gate terminal connected to each other to form a second diode connected load structure;
an eighth transistor (732) having a first terminal connected to the second terminal of the seventh transistor (731) and a gate terminal to which the reference voltage (VREF) is input; and
a second resistor (733) having a first terminal connected to a second terminal of the eighth transistor (732), and a second terminal connected to the ground, and
the third circuit (720) includes:
a third transistor (721) having a first terminal connected to the line that supplies the power voltage (VDD), and a gate terminal connected to the second and gate terminals of the first transistor (711);
a fourth transistor (722) having a first terminal connected to a second terminal of the third transistor (721), and a second terminal connected to the ground;
a fifth transistor (723) having a first terminal connected to the line that supplies the power voltage (VDD), and a gate terminal connected to the second and gate terminals of the seventh transistor (731); and
a sixth transistor (724) having a first terminal and a gate terminal connected to a second terminal of the fourth transistor (722) to form a third diode connected load structure, and a second terminal connected to the ground;
wherein the third circuit is configured to output the control current (I_{VCO}) at a node (C) between the third transistor (721) and the fourth transistor (722).

2. The voltage-current conversion circuit of claim 1, wherein the second circuit (730) is a replica circuit of the first circuit (710).

3. The voltage-current conversion circuit of claim 2, wherein the third circuit (720) is configured to form a current mirror with the second circuit (720) to output a third current (I_{REF3}) corresponding to the second current (I_{REF1}), and output the control current (I_{VCO}) based on the first current (I_{VCONT1}) and the third current (I_{REF3}).

4. The voltage-current conversion circuit of claim 1, wherein the control current (I_{VCO}) is generated based on the difference between the first current (I_{VCONT1}) and the third current (IREF3).

5. The voltage-current conversion circuit of any one of the preceding claims, wherein the second transistor (712) is a first NMOS transistor (712), and the eight transistor (732) is a second NMOS transistor (732).

6. The voltage-current conversion circuit of claim 5, wherein the first NMOS transistor and the second NMOS transistor have the same temperature characteristics.

7. A voltage-controlled oscillator (200), comprising:
the voltage-current conversion circuit (241 and 700) of any of claims 1 to 6; and
a ring oscillator (242) configured to output an output signal with a frequency corresponding to the control current.

8. A phase-locked loop circuit (200), comprising:
a phase detector (210) configured to detect a phase difference between a first input signal (IN) and a second input signal (CLK);
a filter (230) configured to charge or discharge based on the phase difference;
the voltage-current conversion circuit (241 and 700) of any one of claims 1 to 6; and
an oscillator (242) configured to output an output signal with a frequency corresponding to the control current.

## Patentansprüche

1. Spannungs-Strom-Umwandlungsschaltung (241 und 700) aufweisend:
eine erste Schaltung (710), die konfiguriert ist, eine Steuerspannung (VCONT) zu empfangen und einen ersten Strom (I_{VCONT1}) gemäß der Steuerspannung auszugeben;
eine zweite Schaltung (730), die konfiguriert ist, eine Referenzspannung (VREF) zu empfangen und einen zweiten Strom (I_{REF1}) gemäß der Referenzspannung auszugeben; und
eine dritte Schaltung (720), die konfiguriert ist, einen Steuerstrom (I_{VCO}) gemäß der Steuerspannung (VCONT) basierend auf dem ersten Strom (I_{VCONT1}) und dem zweiten Strom (I_{REF1}) auszugeben,
wobei
die erste Schaltung (710) aufweist:
einen ersten Transistor (711) mit einem ersten Anschluss, der mit einer Leitung verbunden ist, die eine Leistungsspannung (VDD) liefert, und einem zweiten Anschluss und einem Gate-Anschluss, die miteinander verbunden sind, um eine erste mit einer Diode verbundene Laststruktur zu bilden;
einen zweiten Transistor (712) mit einem ersten Anschluss, der mit dem zweiten und dem Gate-Anschluss des ersten Transistors (711) verbunden ist, und einem Gate-Anschluss, in den die Steuerspannung (VCONT) eingegeben wird; und
einen ersten Widerstand (713) mit einem ersten Anschluss, der mit einem zweiten Anschluss des zweiten Transistors (712) verbunden ist, und einem zweiten Anschluss, der mit einer Masse verbunden ist,
wobei die zweite Schaltung (730) aufweist:
einen siebten Transistor (731) mit einem ersten Anschluss, der mit der Leitung verbunden ist, die die Leistungsspannung (VDD) liefert, und einem zweiten Anschluss und einem Gate-Anschluss, die miteinander verbunden sind, um eine zweite mit einer Diode verbundene Laststruktur zu bilden;
einen achten Transistor (732) mit einem ersten Anschluss, der mit dem zweiten Anschluss des siebten Transistors (731) verbunden ist, und einem Gate-Anschluss, in den die Referenzspannung (VREF) eingegeben wird; und
einen zweiten Widerstand (733) mit einem ersten Anschluss, der mit einem zweiten Anschluss des achten Transistors (732) verbunden ist, und einem zweiten Anschluss, der mit der Masse verbunden ist, und
wobei die dritte Schaltung (720) aufweist:
einen dritten Transistor (721) mit einem ersten Anschluss, der mit der Leitung verbunden ist, die die Leistungsspannung (VDD) liefert, und einem Gate-Anschluss, der mit dem zweiten und dem Gate-Anschluss des ersten Transistors (711) verbunden ist;
einen vierten Transistor (722) mit einem ersten Anschluss, der mit einem zweiten Anschluss des dritten Transistors (721) verbunden ist, und einem zweiten Anschluss, der mit der Masse verbunden ist;
einen fünften Transistor (723) mit einem ersten Anschluss, der mit der Leitung verbunden ist, die die Leistungsspannung (VDD) liefert, und einem Gate-Anschluss, der mit dem zweiten und dem Gate-Anschluss des siebten Transistors (731) verbunden ist; und
einen sechsten Transistor (724) mit einem ersten Anschluss und einem Gate-Anschluss, die mit einem zweiten Anschluss des vierten Transistors (722) verbunden sind, um eine dritte mit einer Diode verbundene Laststruktur zu bilden, und einem zweiten Anschluss, der mit der Masse verbunden ist;
wobei die dritte Schaltung konfiguriert ist, den Steuerstrom (I_{VCO}) an einem Knoten (C) zwischen dem dritten Transistor (721) und dem vierten Transistor (722) auszugeben.

2. Spannungs-Strom-Umwandlungsschaltung nach Anspruch 1, wobei die zweite Schaltung (730) eine Replikatschaltung der ersten Schaltung (710) ist.

3. Spannungs-Strom-Umwandlungsschaltung nach Anspruch 2, wobei die dritte Schaltung (720) konfiguriert ist, einen Stromspiegel mit der zweiten Schaltung (720) zu bilden, um einen dritten Strom (I_{REF3}) gemäß dem zweiten Strom (I_{REF1}) auszugeben, und den Steuerstrom (I_{VCO}) basierend auf dem ersten Strom (I_{VCONT1}) und dem dritten Strom (I_{REF3}) auszugeben.

4. Spannungs-Strom-Umwandlungsschaltung nach Anspruch 1, wobei der Steuerstrom (I_{VCO}) basierend auf der Differenz zwischen dem ersten Strom (I_{VCONT1}) und dem dritten Strom (I_{REF3}) erzeugt wird.

5. Spannungs-Strom-Umwandlungsschaltung nach einem der vorhergehenden Ansprüche, wobei der zweite Transistor (712) ein erster NMOS-Transistor (712) ist, und der achte Transistor (732) ein zweiter NMOS-Transistor (732) ist.

6. Spannungs-Strom-Umwandlungsschaltung nach Anspruch 5, wobei der erste NMOS-Transistor und der zweite NMOS-Transistor die gleichen Temperatureigenschaften aufweisen.

7. Spannungsgesteuerter Oszillator (200) aufweisend:
die Spannungs-Strom-Umwandlungsschaltung (241 und 700) nach einem der Ansprüche 1 bis 6; und
einen Ringoszillator (242), der konfiguriert ist, ein Ausgangssignal mit einer Frequenz gemäß dem Steuerstrom auszugeben.

8. Phasenregelkreisschaltung (200) aufweisend:
einen Phasendetektor (210), der konfiguriert ist, eine Phasendifferenz zwischen einem ersten Eingangssignal (IN) und einem zweiten Eingangssignal (CLK) zu detektieren;
einen Filter (230), der konfiguriert ist, basierend auf der Phasendifferenz zu laden oder zu entladen;
die Spannungs-Strom-Umwandlungsschaltung (241 und 700) nach einem der Ansprüche 1 bis 6; und
einen Oszillator (242), der konfiguriert ist, ein Ausgangssignal mit einer Frequenz gemäß dem Steuerstrom auszugeben.

## Revendications

1. Circuit de conversion courant-tension (241 et 700), comprenant :
un premier circuit (710) configuré pour recevoir une tension de commande (VCONT) et émettre un premier courant (I_{VCONTI}) correspondant à la tension de commande ;
un deuxième circuit (730) configuré pour recevoir une tension de référence (VREF) et émettre un deuxième courant (I_{REFI}) correspondant à la tension de référence ; et
un troisième circuit (720) configuré pour émettre un courant de commande (I_{VCO}) correspondant à la tension de commande (VCONT) sur la base du premier courant (I_{VCONTI}) et du deuxième courant (I_{REFI}),
le premier circuit (710) comprenant :
un premier transistor (711) possédant une première borne connectée à une ligne fournissant une tension d'alimentation (VDD), et une deuxième borne et une borne de grille connectées l'une à l'autre pour former une première structure de charge connectée par diode ;
un deuxième transistor (712) possédant une première borne connectée à la deuxième borne et à la borne de grille du premier transistor (711), et une borne de grille dans laquelle est introduite la tension de commande (VCONT) ; et
une première résistance (713) possédant une première borne connectée à une deuxième borne du deuxième transistor (712), et une deuxième borne reliée à la masse,
le deuxième circuit (730) comprenant :
un septième transistor (731) possédant une première borne connectée à la ligne fournissant la tension d'alimentation (VDD), et une deuxième borne et une borne de grille connectées l'une à l'autre pour former une deuxième structure de charge connectée par diode ;
un huitième transistor (732) possédant une première borne connectée à la deuxième borne du septième transistor (731), et une borne de grille dans laquelle est introduite la tension de référence (VREF) ; et
une deuxième résistance (733) possédant une première borne connectée à une deuxième borne du huitième transistor (732), et une deuxième borne reliée à la masse, et
le troisième circuit (720) comprenant :
un troisième transistor (721) possédant une première borne connectée à la ligne fournissant la tension d'alimentation (VDD), et une borne de grille connectée à la deuxième borne et à la borne de grille du premier transistor (711) ;
un quatrième transistor (722) possédant une première borne connectée à une deuxième borne du troisième transistor (721), et une deuxième borne reliée à la masse ;
un cinquième transistor (723) possédant une première borne connectée à la ligne fournissant la tension d'alimentation (VDD), et une borne de grille connectée à la deuxième borne et à la borne de grille du septième transistor (731) ; et
un sixième transistor (724) possédant une première borne et une borne de grille connectées à une deuxième borne du quatrième transistor (722) pour former une troisième structure de charge connectée par diode, et une deuxième borne reliée à la masse ;
le troisième circuit étant configuré pour émettre le courant de commande (I_{VCO}) à un nœud (C) entre le troisième transistor (721) et le quatrième transistor (722).

2. Circuit de conversion courant-tension selon la revendication 1, le deuxième circuit (730) étant un circuit de réplique du premier circuit (710).

3. Circuit de conversion courant-tension selon la revendication 2, le troisième circuit (720) étant configuré pour former un miroir de courant avec le deuxième circuit (720) pour émettre un troisième courant (I_{REF3}) correspondant au deuxième courant (I_{REFI}), et émettre le courant de commande (I_{VCO}) d'après le premier courant (I_{VCONTI}) et le troisième courant (I_{REF3}).

4. Circuit de conversion courant-tension selon la revendication 1, le courant de commande (I_{VCO}) étant généré en fonction de la différence entre le premier courant (I_{VCONTI}) et le troisième courant (I_{REF3}),

5. Circuit de conversion courant-tension selon une quelconque des revendications précédentes, le deuxième transistor (712) étant un premier transistor NMOS (712), et le huitième transistor (732) étant un deuxième transistor NMOS (732).

6. Circuit de conversion courant-tension selon la revendication 5, le premier transistor NMOS et le deuxième transistor NMOS présentant les mêmes caractéristiques de température.

7. Oscillateur commandé en tension (200) comprenant :
un circuit de conversion courant-tension (241 et 700) selon une quelconque des revendications 1 à 6 ; et
un oscillateur annulaire (242) configuré pour émettre un signal de sortie dont la fréquence correspond au courant de commande.

8. Circuit d'asservissement de phase (200) comprenant :
un détecteur de phase (210) configuré pour détecter une différence de phase entre un premier signal d'entrée (IN) et un deuxième signal d'entrée (CLK) ;
un filtre (230) configuré pour charger ou décharger en fonction de la différence de phase ;
le circuit de conversion courant-tension (241 et 700) selon une quelconque des revendications 1 à 6 ; et
un oscillateur (242) configuré pour émettre un signal de sortie dont la fréquence correspond au courant de commande.
